# EUROPEAN PATENT SPECIFICATION

(11) **EP 1 461 985 B1**
(45) Date of publication and mention of the grant of the patent: **22.10.2014**
(21) Application number: 03789847.5
(22) Date of filing: 20.11.2003
(51) Int. Cl.: H05K 1/11, H05K 3/42, H05K 1/02, H05K 1/18

(54) **TECHNIQUE FOR ACCOMMODATING ELECTRONIC COMPONENTS ON A MULTILAYER SIGNAL ROUTING DEVICE**
TECHNIK ZUR AUFNAHME VON ELEKTRONISCHEN BAUTEILEN AUF EINER MEHRSCHICHTIGEN SIGNALLEITVORRICHTUNG
TECHNIQUE POUR LOGER DES COMPOSANTS ELECTRONIQUES SUR UN DISPOSITIF DE ROUTAGE DE SIGNAL MULTICOUCHE

(30) Priority: 20.11.2002 US 427865 P
(43) Date of publication of application: 29.09.2004
(60) Divisional application: 12161156.0
(73) Proprietor: Rockstar Consortium US LP, Richardson, TX 75082 (US)
(72) Inventor: KWONG, Herman, Kanata, Ontario K2L 3S2 (CA); DIFILIPPO, Luigi, Kanata, Ontario K2T 1C7 (CA); DUXBURY, Guy, Nepean, Ontario K2H 6K3 (CA); MARCANTI, Larry, Allen, TX 75005 (US)
(74) Representative: Coyle, Philip Aidan
(86) International application number: PCT/US2003/037069
(87) International publication number: WO 2004/047508

(56) References cited:
- WO-A-01/58224
- US-A- 5 384 433
- US-A1- 2002 008 314
- US-A1- 2003 043 560
- US-B1- 6 388 890
- PATENT ABSTRACTS OF JAPAN vol. 1997, no. 12, 25 December 1997 (1997-12-25) -& JP 09 223861 A (CANON INC), 26 August 1997 (1997-08-26)
- "PRINTED CIRCUIT BOARD TERMINATION NETWORK FOR HIGH SPEED SIGNALS" RESEARCH DISCLOSURE, KENNETH MASON PUBLICATIONS, HAMPSHIRE, GB, no. 417, January 1999 (1999-01), pages 163-166, XP000888521 ISSN: 0374-4353

## Description

### FIELD OF THE Invention

The present invention relates generally to multilayer signal routing devices and, more particularly, to a technique for accommodating electronic components on a multilayer signal routing device.

### BACKGROUND OF THE INVENTION

The making of electrical connections between electronic components has long been accomplished using printed circuit boards (PCBs). The first such circuit boards had only a single routing layer on a top surface thereof for routing electrical signals between electronic components mounted thereon. These single routing layer circuit boards have severe limitations with regard to the number of electrical signals that can be routed between electronic components mounted on the same circuit board. That is, the number of electrical signals that can be routed between electronic components mounted on a single routing layer circuit board is limited by the amount of area on the single routing layer.

The area limitations associated with single routing layer circuit boards led to the development of multilayer PCBs. Such multilayer PCBs may be either single or double-sided and may have multiple routing layers on the surface of and buried within the multilayer PCBs. Thus, such multilayer PCBs have allowed a large increase in the number of electrical signals that may be routed between electronic components mounted on the same circuit board.

The use of multilayer PCBs has been particularly beneficial when using electronic components having high-density packages. That is, electronic components having high-density packages generally require multiple layers of a multilayer PCB to make electrical connections with other electronic components mounted on the same circuit board. In fact, the density of electronic component packages typically dictates the number of layers that must be provided by the multilayer PCB upon which the electronic components are mounted. While the number of layers that may be provided by a multilayer PCB is theoretically unlimited, reliability and other problems occur when the number of layers in a multilayer PCB exceeds a reasonable number, particularly when trying to route high-speed electrical signals between electronic components. For example, when making electrical connections between different layers in multilayer PCBs, a combination of electrically conductive traces and electrically conductive vias are generally used. While electrically conductive vias allow direct vertical electrical connections to be made between different layers within a multilayer PCB, there are intrinsic parasitics associated with these electrically conductive vias that can adversely affect the performance of signals propagating therethrough. That is, these electrically conductive vias have intrinsic parasitic resistance, capacitance, and inductance, which can adversely affect signals propagating along each electrically conductive via. In addition, these intrinsic parasitics can also have an adverse effect on the manufacturability of a PCB and thus the cost thereof. Because of their adverse affect on signal performance, these intrinsic parasitics can also limit the bandwidth of signals propagating along each electrically conductive via. These adverse affects only increase as the number of layers in a multilayer PCB increase.

To alleviate at least some of the above-mentioned adverse effects, it is often helpful to have resistive, capacitive, and/or inductive components electrically connected in series and/or parallel with an electrically conductive via, which is also electrically connected to a signal driver contact of an electronic component. However, this is often difficult to achieve since the signal driver contact may be located within the interior of a contact array of the electronic component, and thus there is no place to mount the resistive, capacitive, and/or inductive components. Even if the signal driver contact is located along the periphery of a contact array of the electronic component, there may still be no place to mount the resistive, capacitive, and/or inductive components since electronic components are now being placed ever closer together on the surfaces of PCB's and other types of multilayer signal routing devices.

One proposed solution to the problem of mounting resistive, capacitive, and/or inductive components since electronic components near a signal driver contact of an electronic component is to bury or embed the resistive, capacitive, and/or inductive components within a PCB or other type of multilayer signal routing device. However, the cost and maturity of suitable technologies for this proposed solution make it impractical.

U. S. Patent No. 6,388, 890 discloses a multilayer PCB including vias and micro-vias combining to provide areas in a secondary surface of the PCB. These areas are used to route signals towards the edge of the board. U. S. Patent No. 6,388, 890 however is not concerned with mounting components to both a primary and secondary surface of the PCB nor how to optimise the arrangement of such a PCB.

In view of the foregoing, it would be desirable to provide a technique for mounting resistive, capacitive, and/or inductive components on a multilayer signal routing device near a signal driver contact of an electronic component that overcomes the above-described inadequacies and shortcomings.

### SUMMARY OF THE INVENTION

According to the present invention, there is provided a method for accommodating electronic components on a multilayer signal routing device according to claim 1 and in a further aspect there is provided a multilayer signal routing device according to claim 9.

### BRIEF DESCRIPTION OF THE DRAWINGS

In order to facilitate a fuller understanding of the present invention, reference is now made to the accompanying drawings, in which like elements are referenced with like numerals. These drawings should not be construed as limiting the present invention, but are intended to be exemplary only.
Figure 1 shows a portion of a secondary side of a multilayer signal routing device having signal routing channels.
Figure 2 shows the portion of the secondary side of the multilayer signal routing device of Figure 1 having additional electronic components mounted in the signal routing channels in accordance with an embodiment of the present invention.
Figure 2A shows the portion of the secondary side of the multilayer signal routing device of Figure 1 having additional electronic components, including logic devices, mounted in the signal routing channels in accordance with an embodiment of the present invention.
Figure 3 shows an alternate embodiment of a portion of a secondary side of a multilayer signal routing device having additional electronic components mounted in horizontal signal routing channels in accordance with an embodiment of the present invention.
Figure 4 shows an alternate embodiment of a portion of a secondary side of a multilayer signal routing device having additional electronic components mounted in vertical signal routing channels in accordance with an embodiment of the present invention.
Figure 5 shows an alternate embodiment of a portion of a secondary side of a multilayer signal routing device having additional electronic components mounted in proximate horizontal signal routing channels in accordance with an embodiment of the present invention.
Figure 6 shows an alternate embodiment of a portion of a secondary side of a multilayer signal routing device having additional electronic components mounted in proximate vertical signal routing channels in accordance with an embodiment of the present invention.
Figure 7 shows an alternate embodiment of a portion of a secondary side of a multilayer signal routing device having additional electronic components mounted in signal routing channels configured as a pair of rectangular-shaped pockets or cavities in accordance with an embodiment of the present invention.
Figure 8 shows an alternate embodiment of a portion of a secondary side of a multilayer signal routing device having additional electronic components mounted in a signal routing channel configured as a single rectangular-shaped pocket or cavity in accordance with an embodiment of the present invention.
Figure 9 shows an alternate embodiment of a portion of a secondary side of a multilayer signal routing device having signal routing channels configured in both horizontal and vertical directions for accommodating additional electronic components in both the horizontal and vertical directions in accordance with an embodiment of the present invention.
Figure 10 shows an alternate embodiment of a portion of a secondary side of a multilayer signal routing device having signal routing channels configured in both horizontal and diagonal directions for accommodating additional electronic components in both the horizontal and diagonal directions in accordance with an embodiment of the present invention.
Figure 11 shows an alternate embodiment of a portion of a secondary side of a multilayer signal routing device having signal routing channels configured in diagonal directions for accommodating additional electronic components in the diagonal directions in accordance with an embodiment of the present invention.
Figure 12 shows an alternate embodiment of a portion of a secondary side of a multilayer signal routing device having signal routing channels configured in vertical, horizontal, and diagonal directions for accommodating additional electronic components in the vertical, horizontal, and diagonal directions in accordance with an embodiment of the present invention.
Figure 13 shows an alternate embodiment of a portion of a secondary side of a multilayer signal routing device having signal routing channels configured in vertical, horizontal, and enclosed diagonal directions for accommodating additional electronic components in the vertical, horizontal, and enclosed diagonal directions in accordance with an embodiment of the present invention.

### DETAILED DESCRIPTION OF EXEMPLARY EMBODIMENT (S)

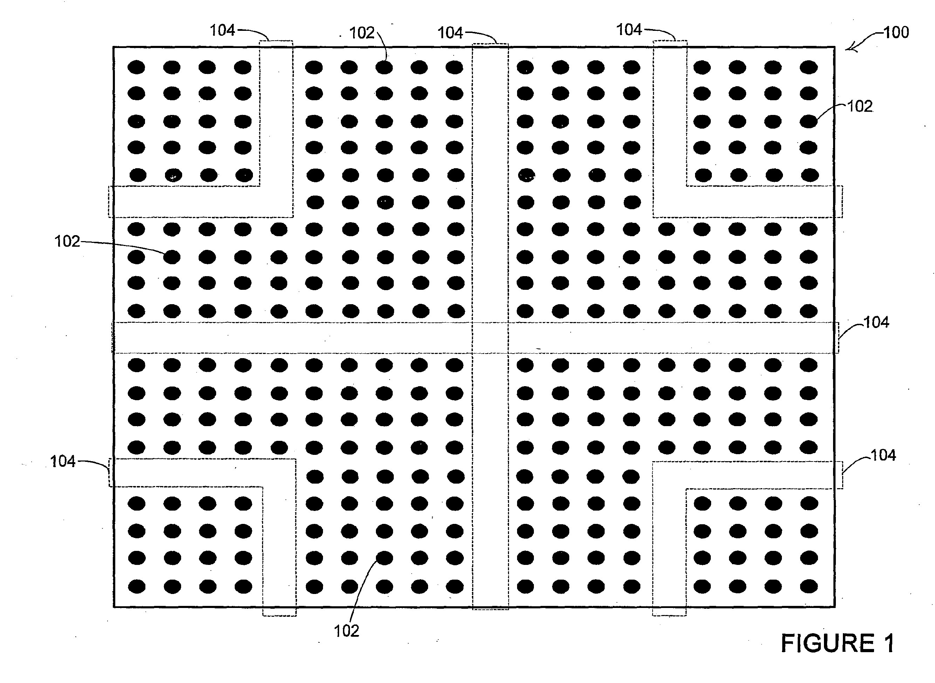

Referring to Figure 1, there is shown a portion of a secondary side of a multilayer signal routing device 100. The multilayer signal routing device portion 100 comprises a plurality of electrically conductive pads 102 formed thereon, each of which is preferably electrically connected to an electrically conductive via (not shown) formed in the multilayer signal routing device portion 100. The plurality of electrically conductive pads 102, through respective ones of the electrically conductive vias, are electrically connected to electrically conductive pads (not shown) formed on a primary side (i. e. , the opposite side) of the multilayer signal routing device portion 100. These electrically conductive pads formed on the primary side of the multilayer signal routing device portion 100 are electrically connected to electrically conductive contacts of an electronic component (not shown) that is mounted on the primary side of the multilayer signal routing device portion 100.

In the embodiment of Figure 1, the electronic component that is mounted on the primary side of the multilayer signal routing device portion 100 has a 20 x 20 array of electrically conductive contacts formed thereon. As shown in Figure 1, some of the electrically conductive contacts in the 20 x 20 array of electrically conductive contacts formed on the electronic component are not electrically connected to respective ones of the electrically conductive pads 102 formed on the secondary side of the multilayer signal routing device portion 100. Those electrically conductive contacts of the electronic component that are not electrically connected to respective ones of the electrically conductive pads 102 formed on the secondary side of the multilayer signal routing device portion 100 may instead be electrically connected to additional electrically conductive pads formed on the primary side of the multilayer signal routing device portion 100. These additional electrically conductive pads formed on the primary side of the multilayer signal routing device portion 100 may in turn be electrically connected to micro-vias (not shown) formed in the multilayer signal routing device portion 100. These micro-vias may be arranged to form signal routing channels 104 on the secondary side of the multilayer signal routing device portion 100, as well as within one or more internal layers of the multilayer signal routing device portion 100, as described in the above-referenced techniques for reducing the number of layers in a multilayer signal routing device.

At this point it should be noted that some of those electrically conductive contacts of the electronic component that are not electrically connected to respective ones of the electrically conductive pads 102 formed on the secondary side of the multilayer signal routing device portion 100 may not be electrically connected to any electrically conductive pads formed on the primary side of the multilayer signal routing device portion 100. For example, some of those electrically conductive contacts of the electronic component that are not electrically connected to respective ones of the electrically conductive pads 102 formed on the secondary side of the multilayer signal routing device portion 100 may be used for testing the electronic component when the electronic component is not mounted on the multilayer signal routing device portion 100.

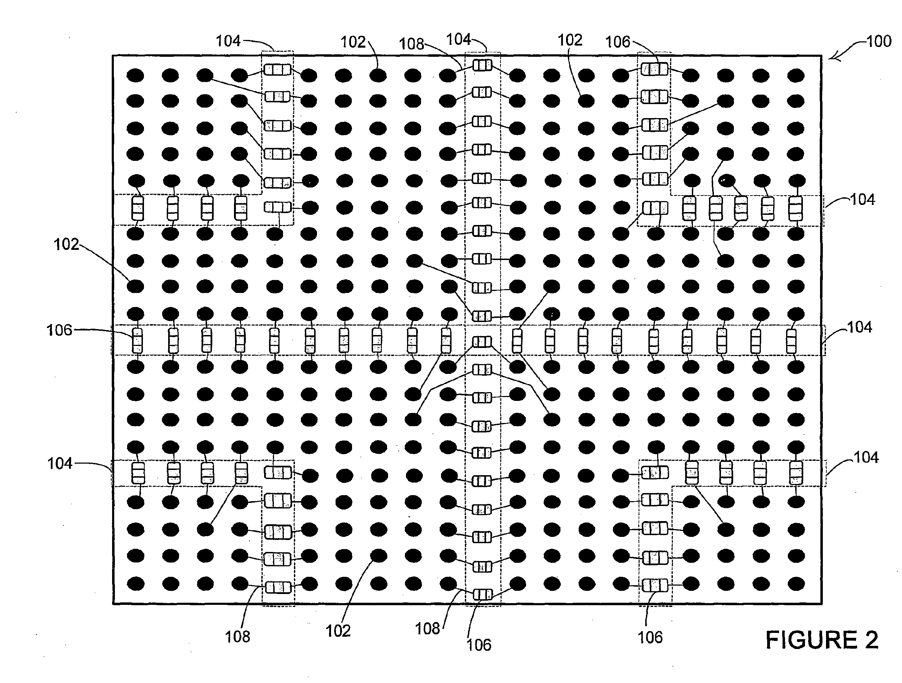

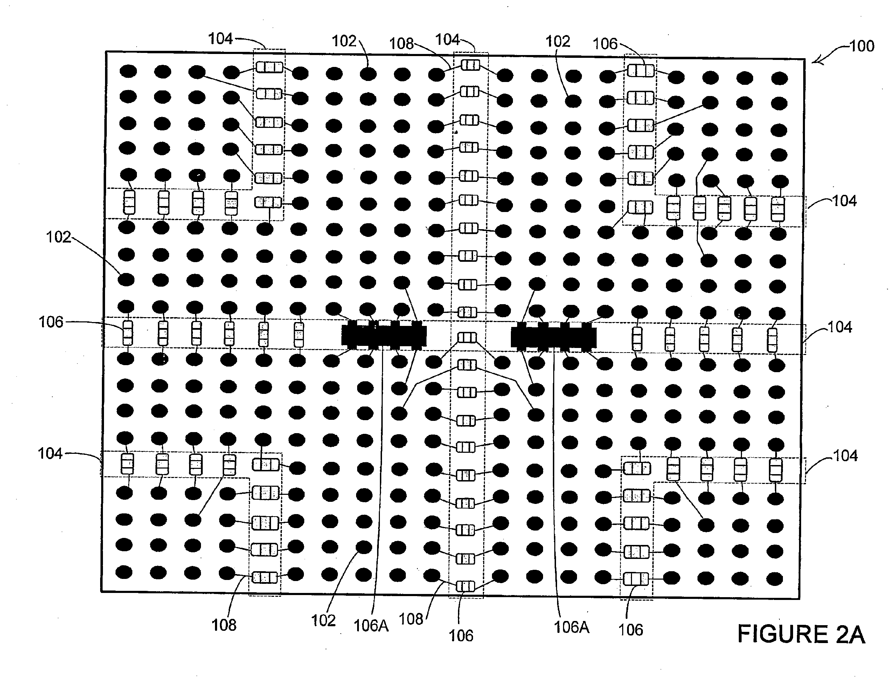

While the signal routing channels 104 are very beneficial for reducing the number of layers in a multilayer signal routing device as described in the above-referenced techniques, the signal routing channels 104 may also be used to provide valuable space for mounting additional electronic components on the secondary side of the multilayer signal routing device portion 100 in accordance with an embodiment of the present invention. For example, referring to Figure 2, there are shown multiple additional electronic components 106 mounted on the secondary side of the multilayer signal routing device portion 100 within the signal routing channels 104. As also shown in Figure 2, the multiple additional electronic components 106 are electrically connected to respective ones of the electrically conductive pads 102 formed on the secondary side of the multilayer signal routing device portion 100 by electrical connections 108.

At this point it should be noted that, as shown in Figure 2, the multiple additional electronic components 106 may be discrete resistive, capacitive, and/or inductive components. Alternatively, as shown in Figure 2A, one or more of the multiple additional electronic components 106A may be active electronic components such as, for example, logic circuitry.

It should also be noted that the electrical connections 108 may be electrically conductive traces formed on the secondary side of the multilayer signal routing device portion 100. In such a case, the multiple additional electronic components 106 may have electrically conductive contacts (e.g., surface mount pads) which may be mounted on respective mating electrically conductive pads (not shown) formed on the secondary side of the multilayer signal routing device portion 100. Of course, these mating electrically conductive pads formed on the secondary side of the multilayer signal routing device portion 100 are electrically connected to respective electrically conductive traces.

Alternatively, the electrical connections 108 may be electrically conductive leads associated with the multiple additional electronic components 106. In such a case, the multiple additional electronic components 106 may be mounted on the secondary side of the multilayer signal routing device portion 100 with a non-electrically conductive adhesive while the electrically conductive leads are separately electrically connected to respective ones of the electrically conductive pads 102. Indeed, the multiple additional electronic components 106 may even be mounted on top of surface mount components, which themselves are mounted on the secondary side of the multilayer signal routing device portion 100 within the signal routing channels 104, thereby forming stacked component structures so as to further increase component density on the multilayer signal routing device portion 100.

As shown in Figure 2, the signal routing channels 104 may be used to provide valuable space for mounting the additional electronic components 106 on the secondary side of the multilayer signal routing device portion 100 in accordance with an embodiment of the present invention. An important benefit associated with the mounting of these additional electronic components 106 on the secondary side of the multilayer signal routing device portion 100 is that signal integrity may be improved when the additional electronic components 106 (e.g., resistive, capacitive, and/or inductive components) are mounted on the multilayer signal routing device 100 near a signal driver contact of the electronic component. An additional side benefit associated with the mounting of these additional electronic components 106 on the secondary side of the multilayer signal routing device portion 100 is that these additional electronic components 106 may be mounted in an orderly and logical fashion so as to facilitate troubleshooting in a laboratory environment.

At this point it should be noted that an empirical prediction may be made regarding the total amount of space that is required to accommodate all of the additional electronic components 106 that are required for a particular design. For example, assuming a worst case signal-to-ground ratio of 2:1, and that each signal must be attached to one of the additional electronic components 106, the total number of additional electronic components 106 required for an electronic component having M x N array of electrically conductive contacts formed thereon is approximately (M x N)/3. Thus, the total amount of space that is required to accommodate all of the additional electronic components 106 that are required for a particular design is (M x N)/3 * (space required for the additional electronic component 106, including any required clearance surrounding the additional electronic component 106). Once the total amount of space is determined, the required number and size of signal routing channels 104 may be created using the above-referenced techniques for reducing the number of layers in a multilayer signal routing device.

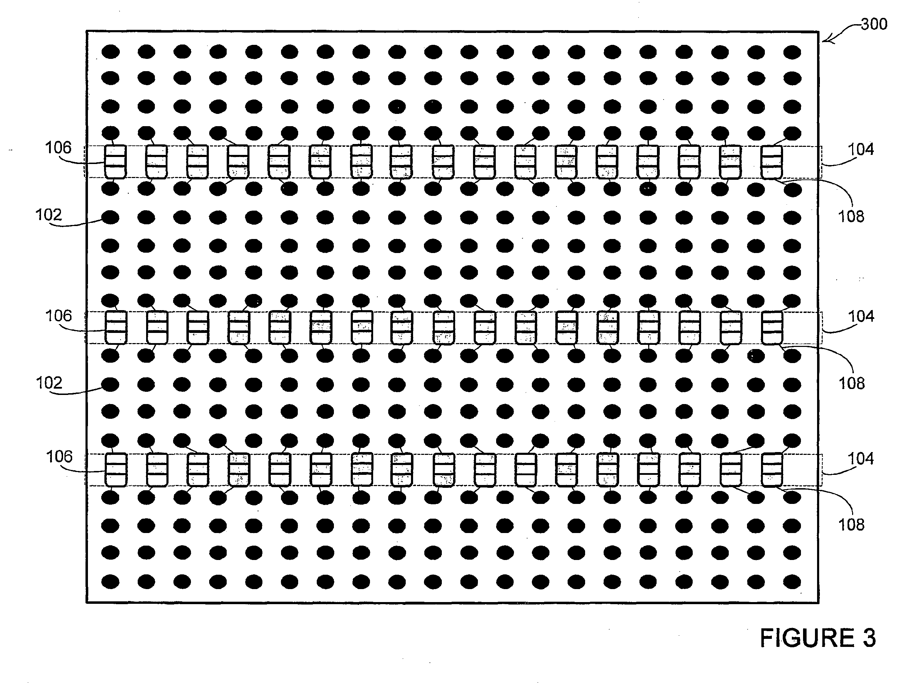

At this point it should be noted that the signal routing channels 104 may be configured in a variety of ways to achieve the total amount of space that is required to accommodate all of the additional electronic components 106. For example, referring to Figure 3, there is shown an alternate embodiment of a portion of a secondary side of a multilayer signal routing device 300. In the embodiment of Figure 3, the signal routing channels 104 are all configured in a horizontal direction for accommodating all of the additional electronic components 106 in a similar horizontal direction.

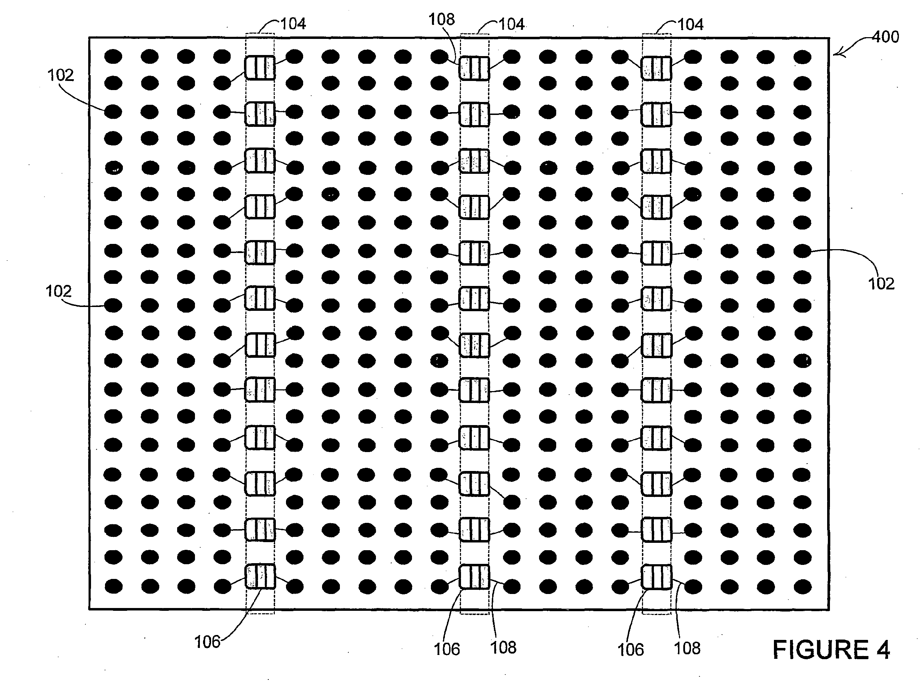

Referring to Figure 4, there is shown another alternate embodiment of a portion of a secondary side of a multilayer signal routing device 400. In the embodiment of Figure 4, the signal routing channels 104 are all configured in a vertical direction for accommodating all of the additional electronic components 106 in a similar vertical direction.

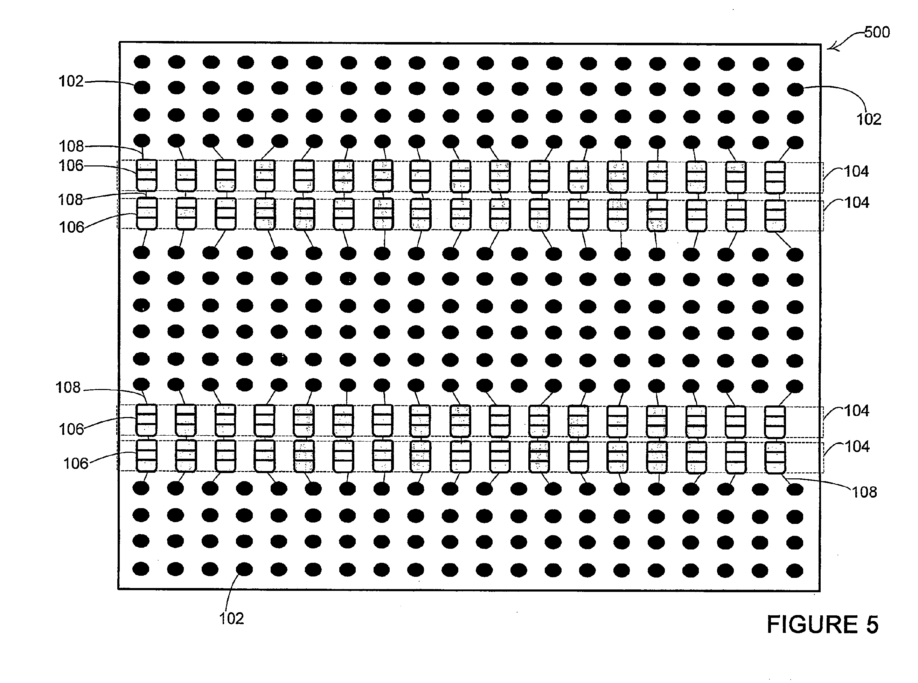

Referring to Figure 5, there is shown another alternate embodiment of a portion of a secondary side of a multilayer signal routing device 500. In the embodiment of Figure 5, the signal routing channels 104 are all configured in a horizontal direction for accommodating all of the additional electronic components 106 in a similar horizontal direction. Also, pairs of the additional electronic components 106 are electrically connected together via electrical connections 108.

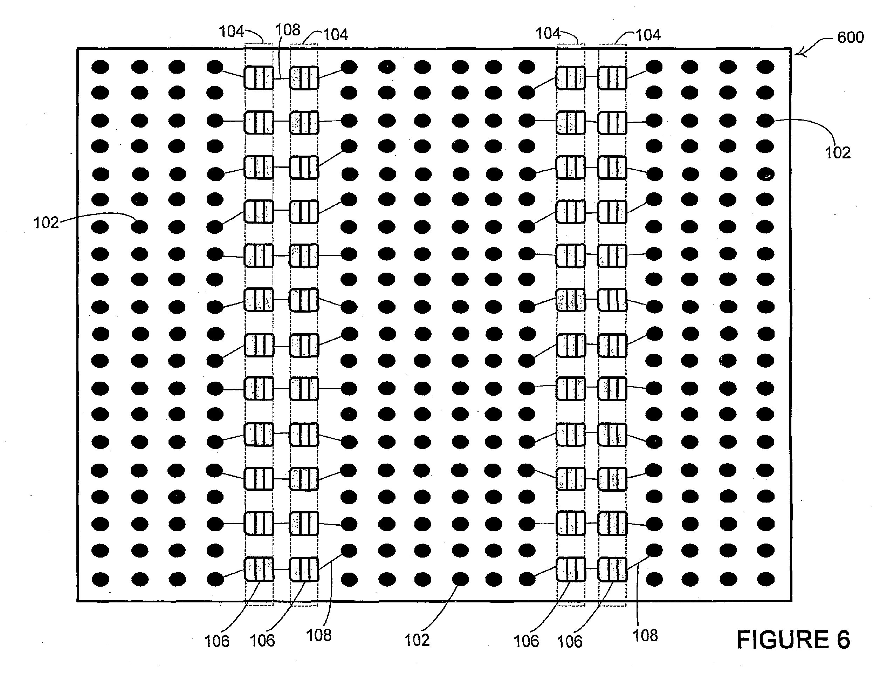

Referring to Figure 6, there is shown another alternate embodiment of a portion of a secondary side of a multilayer signal routing device 600. In the embodiment of Figure 6, the signal routing channels 104 are all configured in a vertical direction for accommodating all of the additional electronic components 106 in a similar vertical direction. Also, pairs of the additional electronic components 106 are electrically connected together via electrical connections 108.

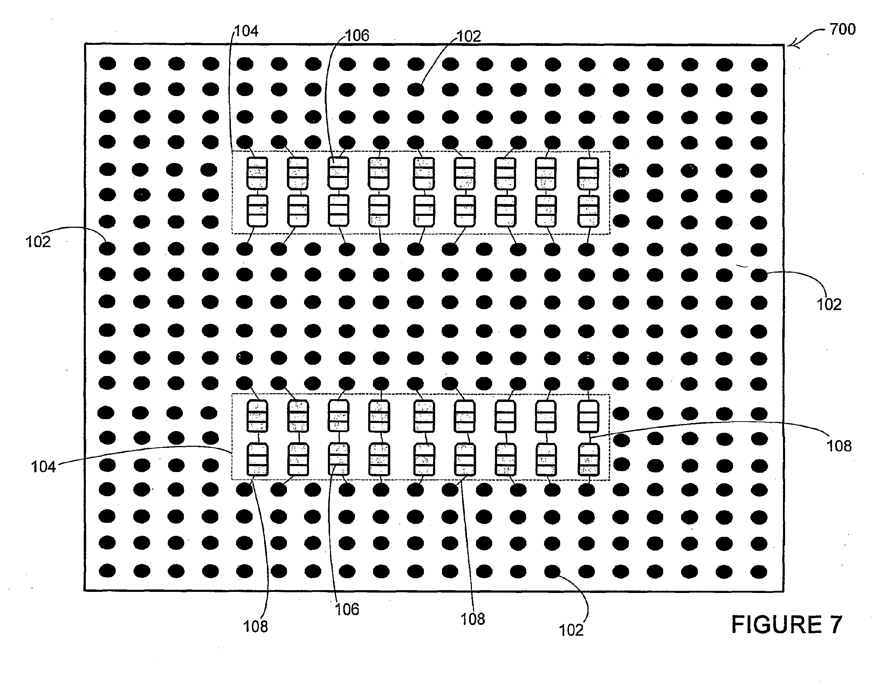

Referring to Figure 7, there is shown another alternate embodiment of a portion of a secondary side of a multilayer signal routing device 700. In the embodiment of Figure 7, the signal routing channels 104 are configured as a pair of rectangular-shaped pockets or cavities surrounded by electrically conductive pads 102 for accommodating all of the additional electronic components 106 within the rectangular-shaped pockets or cavities. Also, pairs of the additional electronic components 106 are electrically connected together via electrical connections 108.

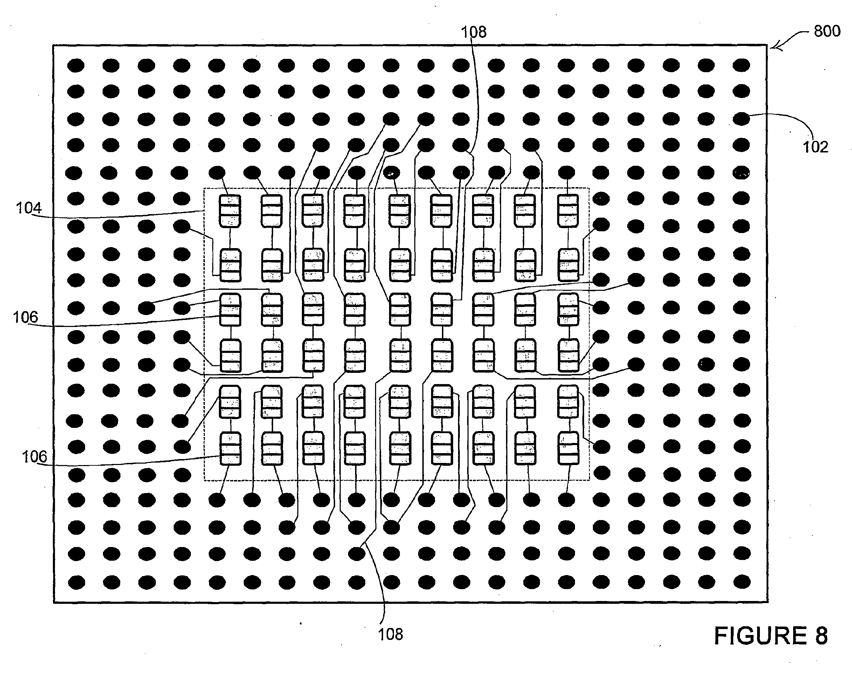

Referring to Figure 8, there is shown another alternate embodiment of a portion of a secondary side of a multilayer signal routing device 800. In the embodiment of Figure 8, the signal routing channel 104 is configured as a single rectangular-shaped pocket or cavity (e.g., formed by combining multiple smaller-width signal routing channels) surrounded by electrically conductive pads 102 for accommodating all of the additional electronic components 106 within the single rectangular-shaped pocket or cavity. Also, pairs of the additional electronic components 106 are electrically connected together via electrical connections 108.

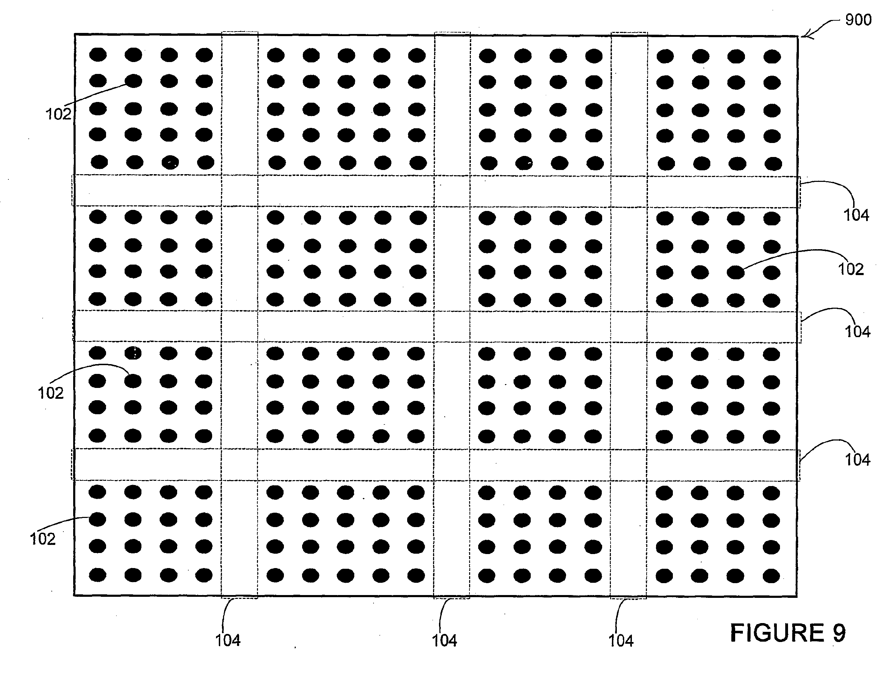

Referring to Figure 9, there is shown another alternate embodiment of a portion of a secondary side of a multilayer signal routing device 900 (although without the additional electronic components 106 shown). In the embodiment of Figure 9, the signal routing channels 104 are configured in both horizontal and vertical directions for accommodating all of the additional electronic components 106 in both the horizontal and vertical directions.

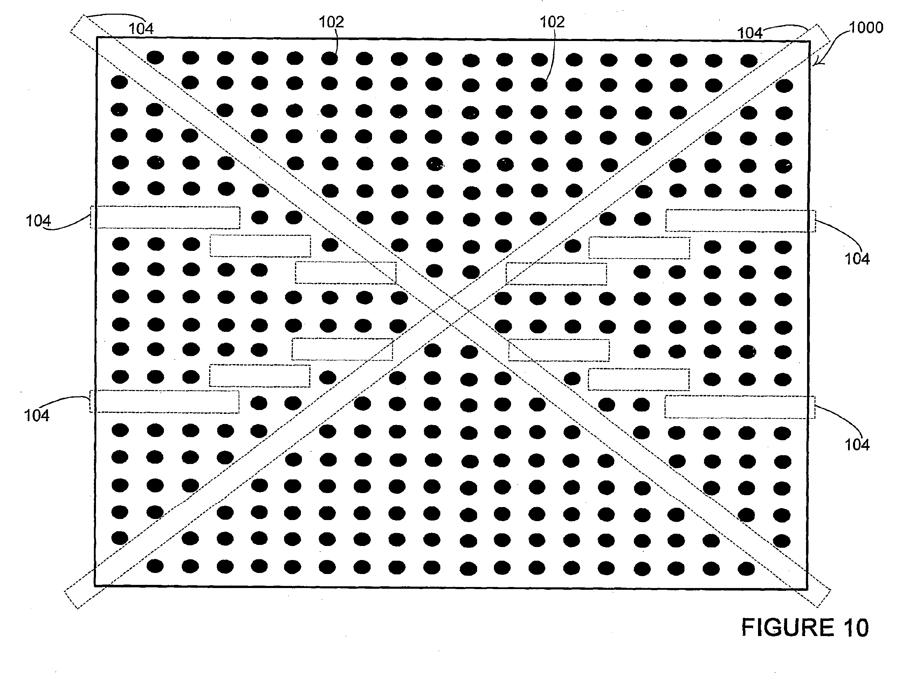

Referring to Figure 10, there is shown another alternate embodiment of a portion of a secondary side of a multilayer signal routing device 1000 (although without the additional electronic components 106 shown). In the embodiment of Figure 10, the signal routing channels 104 are configured in both horizontal and diagonal directions for accommodating all of the additional electronic components 106 in both the horizontal and diagonal directions.

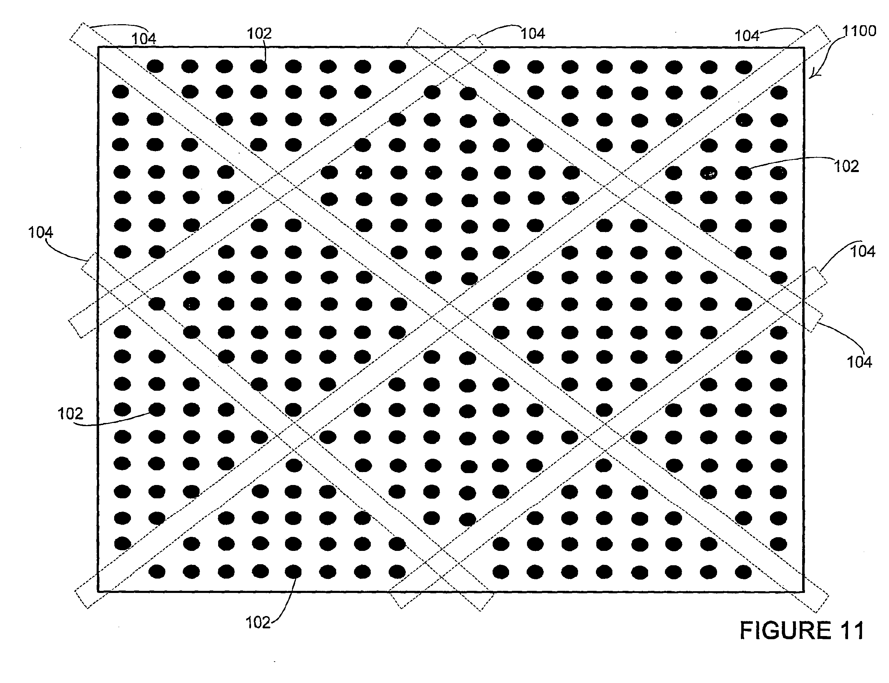

Referring to Figure 11, there is shown another alternate embodiment of a portion of a secondary side of a multilayer signal routing device 1100 (although without the additional electronic components 106 shown). In the embodiment of Figure 11, the signal routing channels 104 are configured in diagonal directions for accommodating all of the additional electronic components 106 in the diagonal directions.

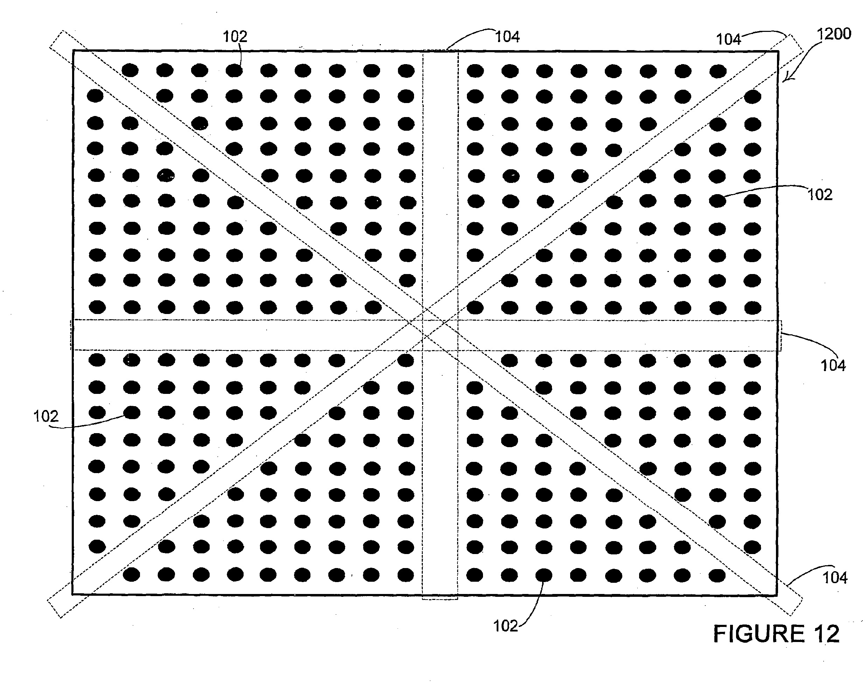

Referring to Figure 12, there is shown another alternate embodiment of a portion of a secondary side of a multilayer signal routing device 1200 (although without the additional electronic components 106 shown). In the embodiment of Figure 12, the signal routing channels 104 are configured in vertical, horizontal, and diagonal directions for accommodating all of the additional electronic components 106 in the vertical, horizontal, and diagonal directions.

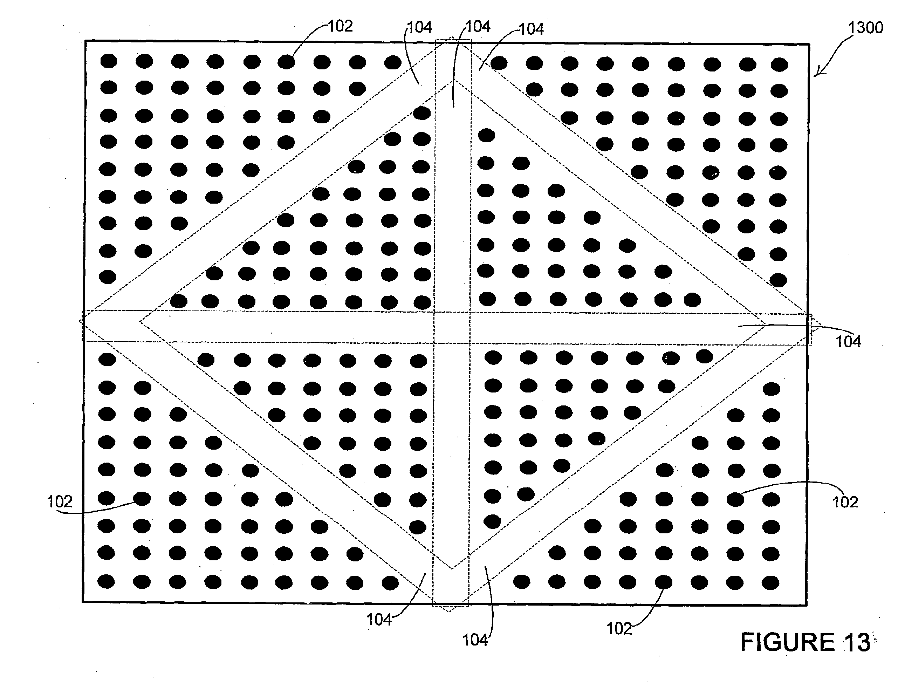

Referring to Figure 13, there is shown another alternate embodiment of a portion of a secondary side of a multilayer signal routing device 1300 (although without the additional electronic components 106 shown). In the embodiment of Figure 13, the signal routing channels 104 are configured in vertical, horizontal, and enclosed diagonal directions for accommodating all of the additional electronic components 106 in the vertical, horizontal, and enclosed diagonal directions.

## Claims

1. A method for accommodating electronic components on a multilayer signal routing device, the method comprising the steps of:
forming a plurality of electrically conductive pads on a primary surface of the multilayer signal routing device opposite a respective plurality of conductive pads (102) formed on a secondary surface of the multilayer signal routing device, said primary surface conductive pads being connected to said secondary surface conductive pads through respective conductive vias;
determining a component space that is required to accommodate a plurality of electronic components on the secondary surface of a multilayer signal routing device;
forming at least one channel (104) on at least the secondary surface of the multilayer signal routing device by not deploying electrically conductive vias in the multilayer signal routing device that extend through to at least the secondary surface of the multilayer signal routing device coinciding with a location of the at least one channel, the at least one channel having a channel space that is equal to or greater than the component space;
forming a group of electrically conductive micro-vias extending from the primary surface into the multilayer signal routing device, but not entirely through the multilayer signal routing device to the secondary surface, said channel coinciding with the location of said group of electrically conductive micro-vias, at least some of said micro-vias being in electrical connection with respective primary surface conductive pads; and
mounting at least a portion of the plurality of electronic components (106) on the secondary surface of the multilayer signal routing device within the at least one channel.

2. The method of claim 1, wherein the step of determining a component space comprises the steps of: determining a number of the plurality of electronic components that are to be mounted on the secondary surface of the multilayer signal routing device; and determining a required space for each of the number of the plurality of electronic components that are to be mounted on the secondary surface of the multilayer signal routing device.

3. The method of claim 1, wherein the step of forming at least one channel comprises the step of: forming at least two relatively aligned electrically conductive microvias in the multilayer signal routing device coinciding with the location of the at least one channel formed on the secondary surface of the multilayer signal routing device.

4. The method of claim 1, wherein at least two relatively aligned electrically conductive micro-vias are formed in the multilayer signal routing device in electrical connection with at least two respective ones of the electrically conductive pads and coinciding with the location of the at least one channel formed on the secondary surface of the multilayer signal routing device.

5. The method of claim 4, further comprising the step of: forming an electrically conductive pad on the secondary surface of the multilayer signal routing device within the at least one channel formed on the secondary surface of the multilayer signal routing device.

6. The method of claim 5, further comprising the step of: forming an electrically conductive trace (108) on the secondary surface of the multilayer signal routing device electrically connected to the electrically conductive pad formed on the secondary surface of the multilayer signal routing device.

7. The method of claim 5, wherein said mounting comprises: mounting at least one of the plurality of electronic components on the secondary surface of the multilayer signal routing device in electrical connection with the electrically conductive pad formed on the secondary surface of the multilayer signal routing device.

8. The method of claim 1, wherein the at least one channel formed on the secondary surface of the multilayer signal routing device has at least one of a vertical, horizontal, and diagonal orientation portion along the surface of the multilayer signal routing device.

9. A multilayer signal routing device comprising:
a primary surface having a plurality of electrically conductive pads formed thereon;
a secondary surface having a plurality of electrically conductive pads (102) formed thereon;
a plurality of conductive vias connecting at least one of said primary surface conductive pads to a respective secondary surface conductive pad;
a group of electrically conductive micro-vias extending from the primary surface into the multilayer signal routing device, but not entirely through the multilayer signal routing device to the secondary surface,
a group of the plurality of primary surface electrically conductive pads in respective electrical connection with the group of electrically conductive micro-vias formed in the multilayer signal routing device; and
a least one channel (104) formed in said secondary surface by not deploying electrically conductive vias in the multilayer signal routing device that extend through to at least the secondary surface of the multilayer signal routing device coinciding with a location of the at least one channel and coinciding with the location of the group of electrically conductive micro-vias, the channel having a channel area on the secondary surface for accommodating an electronic component (106) mounted on the secondary surface.

10. The multilayer signal routing device of claim 9, wherein the secondary surface has an electrically conductive pad formed thereon within the signal routing channel.

11. The multilayer signal routing device of claim 10, wherein the secondary surface has an electrically conductive trace formed thereon, the electrically conductive trace in electrical connection with the electrically conductive pad (102) formed on the secondary surface.

12. The multilayer signal routing device of claim 10, wherein the electronic component is mounted on the secondary surface within the signal routing channel in electrical connection with the electrically conductive pad formed on the secondary surface.

13. The multilayer signal routing device of claim 9, wherein the signal routing channel has at least one of a vertical, horizontal, and diagonal orientation portion along the secondary surface of the multilayer signal routing device.

## Patentansprüche

1. Verfahren zum Aufnehmen von elektronischen Komponenten auf einer mehrschichtigen Signalleitvorrichtung, wobei das Verfahren die folgenden Schritte beinhaltet:
Bilden einer Mehrzahl von elektrisch leitenden Kontaktstellen auf einer primären Fläche der mehrschichtigen Signalleitvorrichtung gegenüber einer jeweiligen Mehrzahl von leitenden Kontaktstellen (102), die auf einer sekundären Fläche der mehrschichtigen Signalleitvorrichtung ausgebildet sind, wobei die leitenden Kontaktstellen der genannten primären Fläche mit den leitenden Kontaktstellen der genannten sekundären Fläche durch jeweilige leitende Durchkontaktierungen verbunden sind;
Ermitteln eines Komponentenraums, der zum Aufnehmen einer Mehrzahl von elektronischen Komponenten auf der sekundären Fläche einer mehrschichtigen Signalleitvorrichtung benötigt wird;
Ausbilden von wenigstens einem Kanal (104) auf wenigstens der sekundären Fläche der mehrschichtigen Signalleitvorrichtung, indem in der mehrschichtigen Signalleitvorrichtung keine elektrisch leitenden Durchkontaktierungen benutzt werden, die zu wenigstens der sekundären Fläche der mehrschichtigen Signalvorrichtung durch verlaufen, die mit einem Ort des wenigstens einen Kanals übereinstimmt, wobei der wenigstens eine Kanal einen Kanalraum hat, der gleich oder größer als der Komponentenraum ist;
Ausbilden einer Gruppe von elektrisch leitenden Mikrodurchkontaktierungen, die von der primären Fläche in die mehrschichtige Signalleitvorrichtung verlaufen, aber nicht ganz durch die mehrschichtige Signalleitvorrichtung zu der sekundären Fläche durch verlaufen, wobei der genannte Kanal mit dem Ort der genannten Gruppe von elektrisch leitenden Mikrodurchkontaktierungen übereinstimmt, wobei wenigstens einige der genannten Mikrodurchkontaktierungen mit jeweiligen leitenden Kontaktstellen der primären Oberfläche in elektrischer Verbindung sind; und
Montieren wenigstens eines Teils der Mehrzahl von elektronischen Komponenten (106) auf der sekundären Fläche der mehrschichtigen Signalleitvorrichtung innerhalb des wenigstens einen Kanals.

2. Verfahren nach Anspruch 1, wobei der Schritt des Ermittelns eines Komponentenraums die folgenden Schritte beinhaltet: Ermitteln einer Anzahl der Mehrzahl der elektronischen Komponenten, die auf der sekundären Fläche der mehrschichtigen Signalleitvorrichtung zu montieren sind; und Ermitteln eines benötigten Raums für jede aus der Anzahl der Mehrzahl der auf der sekundären Fläche der mehrschichtigen Signalleitvorrichtung zu montierenden elektronischen Komponenten.

3. Verfahren nach Anspruch 1, wobei der Schritt des Ausbildens von wenigstens einem Kanal den Schritt des Ausbildens von wenigstens zwei relativ ausgerichteten elektrisch leitenden Mikrodurchkontaktierungen in der mehrschichtigen Signalleitvorrichtung beinhaltet, die mit dem Ort des wenigstens einen auf der sekundären Fläche der mehrschichtigen Signalleitvorrichtung ausgebildeten Kanals übereinstimmen.

4. Verfahren nach Anspruch 1, wobei wenigstens zwei relativ ausgerichtete elektrisch leitende Mikrodurchkontaktierungen in der mehrschichtigen Signalleitvorrichtung in elektrischer Verbindung mit wenigstens zwei jeweiligen der elektrisch leitenden Kontaktstellen und in Übereinstimmung mit dem Ort des wenigstens einen Kanals ausgebildet sind, der auf der sekundären Fläche der mehrschichtigen Signalleitvorrichtung ausgebildet ist.

5. Verfahren nach Anspruch 4, das ferner den folgenden Schritt beinhaltet: Ausbilden einer elektrisch leitenden Kontaktstelle auf der sekundären Fläche der mehrschichtigen Signalleitvorrichtung in dem wenigstens einen Kanal, der auf der sekundären Fläche der mehrschichtigen Signalleitvorrichtung ausgebildet ist.

6. Verfahren nach Anspruch 5, das ferner den folgenden Schritt beinhaltet: Ausbilden einer elektrisch leitenden Bahn (108) auf der sekundären Fläche der mehrschichtigen Signalleitvorrichtung, die mit der elektrisch leitenden Kontaktstelle elektrisch verbunden ist, die auf der sekundären Fläche der mehrschichtigen Signalleitvorrichtung ausgebildet ist.

7. Verfahren nach Anspruch 5, wobei das genannte Montieren Folgendes beinhaltet: Montieren von wenigstens einer aus der Mehrzahl von elektronischen Komponenten auf der sekundären Fläche der mehrschichtigen Signalleitvorrichtung in elektrischer Verbindung mit der auf der sekundären Fläche der mehrschichtigen Signalleitvorrichtung ausgebildeten elektrisch leitenden Kontaktstelle.

8. Verfahren nach Anspruch 1, wobei der wenigstens eine auf der sekundären Fläche der mehrschichtigen Signalleitvorrichtung ausgebildete Kanal einen vertikalen, horizontalen und/oder diagonalen Orientierungsabschnitt entlang der Fläche der mehrschichtigen Signalleitvorrichtung hat.

9. Mehrschichtige Signalleitvorrichtung, die Folgendes umfasst:
eine primäre Fläche mit einer Mehrzahl von darauf ausgebildeten elektrisch leitenden Kontaktstellen;
eine sekundäre Fläche mit einer Mehrzahl von darauf ausgebildeten elektrisch leitenden Kontaktstellen (102);
eine Mehrzahl von leitenden Durchkontaktierungen, die wenigstens eine der leitenden Kontaktstellen der genannten primären Fläche mit einer jeweiligen leitenden Kontaktstelle der sekundären Fläche verbinden;
eine Gruppe von elektrisch leitenden Mikrodurchkontaktierungen, die von der primären Fläche in die mehrschichtige Signalleitvorrichtung, aber nicht ganz durch die mehrschichtige Signalleitvorrichtung zur sekundären Fläche verlaufen,
eine Gruppe der Mehrzahl von elektrisch leitenden Kontaktstellen der primären Fläche in jeweiliger elektrischer Verbindung mit der Gruppe von in der mehrschichtigen Signalleitvorrichtung ausgebildeten elektrisch leitenden Mikrodurchkontaktierungen; und
wenigstens einen Kanal (104), der in der genannten sekundären Fläche ausgebildet ist, indem in der mehrschichtigen Signalleitvorrichtung keine elektrisch leitenden Durchkontaktierungen benutzt werden, die zu wenigstens der sekundären Fläche der mehrschichtigen Signalleitvorrichtung durch verlaufen, die mit einem Ort des wenigstens einen Kanals übereinstimmt und mit dem Ort der Gruppe von elektrisch leitenden Mikrodurchkontaktierungen übereinstimmt, wobei der Kanal einen Kanalbereich auf der sekundären Fläche zum Aufnehmen einer auf der sekundären Fläche montierten elektronischen Komponente (106) hat.

10. Mehrschichtige Signalleitvorrichtung nach Anspruch 9, wobei auf der sekundären Fläche eine elektrisch leitende Kontaktstelle in dem Signalleitkanal ausgebildet ist.

11. Mehrschichtige Signalleitvorrichtung nach Anspruch 10, wobei auf der sekundären Fläche eine elektrisch leitende Bahn ausgebildet ist, wobei die elektrisch leitende Bahn mit der auf der sekundären Fläche ausgebildeten elektrisch leitenden Kontaktstelle (102) in elektrischer Verbindung ist.

12. Mehrschichtige Signalleitvorrichtung nach Anspruch 10, wobei die elektronische Komponente auf der sekundären Fläche in dem Signalleitkanal in elektrischer Verbindung mit der auf der sekundären Fläche ausgebildeten elektrisch leitenden Kontaktstelle montiert ist.

13. Mehrschichtige Signalleitvorrichtung nach Anspruch 9, wobei der Signalleitkanal einen vertikalen, horizontalen und/oder diagonalen Orientierungsabschnitt entlang der sekundären Fläche der mehrschichtigen Signalleitvorrichtung hat.

## Revendications

1. Un procédé d'installation de composants électroniques sur un dispositif d'acheminement de signaux à couches multiples, le procédé comprenant les opérations suivantes :
la formation d'une pluralité de plots électriquement conducteurs sur une surface primaire du dispositif d'acheminement de signaux à couches multiples à l'opposé d'une pluralité respective de plots conducteurs (102) formés sur une surface secondaire du dispositif d'acheminement de signaux à couches multiples, les plots conducteurs de ladite surface primaire étant raccordés aux plots conducteurs de ladite surface secondaire par l'intermédiaire de trous d'interconnexion conducteurs respectifs,
la détermination d'un espace pour composants qui est nécessaire pour installer une pluralité de composants électroniques sur la surface secondaire d'un dispositif d'acheminement de signaux à couches multiples,
la formation d'au moins un canal (104) sur au moins la surface secondaire du dispositif d'acheminement de signaux à couches multiples par le non-déploiement de trous d'interconnexion électriquement conducteurs dans le dispositif d'acheminement de signaux à couches multiples qui s'étendent vers au moins la surface secondaire du dispositif d'acheminement de signaux à couches multiples coïncidant avec un emplacement du au moins un canal, le au moins un canal possédant un espace de canal qui est égal ou supérieur à l'espace pour composants,
la formation d'un groupe de micro-trous d'interconnexion électriquement conducteurs s'étendant de la surface primaire dans le dispositif d'acheminement de signaux à couches multiples, mais pas entièrement au travers du dispositif d'acheminement de signaux à couches multiples vers la surface secondaire, ledit canal coïncidant avec l'emplacement dudit groupe de micro-trous d'interconnexion électriquement conducteurs, au moins certains desdits micro-trous d'interconnexion étant en raccordement électrique avec des plots conducteurs respectifs de la surface primaire, et
le montage d'au moins une partie de la pluralité de composants électroniques (106) sur la surface secondaire du dispositif d'acheminement de signaux à couches multiples à l'intérieur du au moins un canal.

2. Le procédé selon la Revendication 1, où l'opération de détermination d'un espace pour composants comprend les opérations suivantes : la détermination d'un nombre de la pluralité de composants électroniques qui doivent être montés sur la surface secondaire du dispositif d'acheminement de signaux à couches multiples, et la détermination d'un espace nécessaire pour chaque composant du nombre de la pluralité de composants électroniques qui doivent être montés sur la surface secondaire du dispositif d'acheminement de signaux à couches multiples.

3. Le procédé selon la Revendication 1, où l'opération de formation d'au moins un canal comprend l'opération suivante : la formation d'au moins deux micro-trous d'interconnexion électriquement conducteurs relativement alignés dans le dispositif d'acheminement de signaux à couches multiples coïncidant avec l'emplacement du au moins un canal formé sur la surface secondaire du dispositif d'acheminement de signaux à couches multiples.

4. Le procédé selon la Revendication 1, où au moins deux micro-trous d'interconnexion électriquement conducteurs relativement alignés sont formés dans le dispositif d'acheminement de signaux à couches multiples en raccordement électrique avec au moins deux plots respectifs des plots électriquement conducteurs et coïncidant avec l'emplacement du au moins un canal formé sur la surface secondaire du dispositif d'acheminement de signaux à couches multiples.

5. Le procédé selon la Revendication 4, comprenant en outre l'opération suivante : la formation d'un plot électriquement conducteur sur la surface secondaire du dispositif d'acheminement de signaux à couches multiples à l'intérieur du au moins un canal formé sur la surface secondaire du dispositif d'acheminement de signaux à couches multiples.

6. Le procédé selon la Revendication 5, comprenant en outre l'opération suivante : la formation d'une piste électriquement conductrice (108) sur la surface secondaire du dispositif d'acheminement de signaux à couches multiples électriquement raccordée au plot électriquement conducteur formé sur la surface secondaire du dispositif d'acheminement de signaux à couches multiples.

7. Le procédé selon la Revendication 5, où ledit montage comprend : le montage d'au moins un composant de la pluralité de composants électroniques sur la surface secondaire du dispositif d'acheminement de signaux à couches multiples en raccordement électrique avec le plot électriquement conducteur formé sur la surface secondaire du dispositif d'acheminement de signaux à couches multiples.

8. Le procédé selon la Revendication 1, où le au moins un canal formé sur la surface secondaire du dispositif d'acheminement de signaux à couches multiples possède au moins une partie d'orientation parmi une partie d'orientation verticale, horizontale et diagonale le long de la surface du dispositif d'acheminement de signaux à couches multiples.

9. Un dispositif d'acheminement de signaux à couches multiples comprenant :
une surface primaire possédant une pluralité de plots électriquement conducteurs formés sur celle-ci,
une surface secondaire possédant une pluralité de plots électriquement conducteurs (102) formés sur celle-ci,
une pluralité de trous d'interconnexion conducteurs raccordant au moins un des plots conducteurs de ladite surface primaire à un plot conducteur respectif de la surface secondaire,
un groupe de micro-trous d'interconnexion électriquement conducteurs s'étendant de la surface primaire dans le dispositif d'acheminement de signaux à couches multiples, mais pas entièrement au travers du dispositif d'acheminement de signaux à couches multiples vers la surface secondaire,
un groupe de la pluralité de plots électriquement conducteurs de la surface primaire en raccordement électrique respectif avec le groupe de micro-trous d'interconnexion électriquement conducteurs formés dans le dispositif d'acheminement de signaux à couches multiples, et
au moins un canal (104) formé dans ladite surface secondaire par le non-déploiement de trous d'interconnexion électriquement conducteurs dans le dispositif d'acheminement de signaux à couches multiples qui s'étendent vers au moins la surface secondaire du dispositif d'acheminement de signaux à couches multiples coïncidant avec un emplacement du au moins un canal et coïncidant avec l'emplacement du groupe de micro-trous d'interconnexion électriquement conducteurs, le canal possédant une zone de canal sur la surface secondaire destinée à l'installation d'un composant électronique (106) monté sur la surface secondaire.

10. Le dispositif d'acheminement de signaux à couches multiples selon la Revendication 9, où la surface secondaire possède un plot électriquement conducteur formé sur celle-ci à l'intérieur du canal d'acheminement de signaux.

11. Le dispositif d'acheminement de signaux à couches multiples selon la Revendication 10, où la surface secondaire possède une piste électriquement conductrice formée sur celle-ci, la piste électriquement conductrice étant en raccordement électrique avec le plot électriquement conducteur (102) formé sur la surface secondaire.

12. Le dispositif d'acheminement de signaux à couches multiples selon la Revendication 10, où le composant électronique est monté sur la surface secondaire à l'intérieur du canal d'acheminement de signaux en raccordement électrique avec le plot électriquement conducteur formé sur la surface secondaire.

13. Le dispositif d'acheminement de signaux à couches multiples selon la Revendication 9, où le canal d'acheminement de signaux possède au moins une partie d'orientation parmi une partie d'orientation verticale, horizontale et diagonale le long de la surface secondaire du dispositif d'acheminement de signaux à couches multiples.
